# EUROPEAN PATENT SPECIFICATION

(11) **EP 2 180 530 B1**
(45) Date of publication and mention of the grant of the patent: **07.12.2011**
(21) Application number: 08167085.3
(22) Date of filing: 21.10.2008
(51) Int. Cl.: H01L 31/18, H01L 31/103

(54) **A method for patterning a detector crystal, and a semiconductor detector having a patterned crystal**
Verfahren zur Musterung eines Detektorglases und ein Halbleiter-Detektor mit einem gemusterten Glas
Procédé pour la formation de cristal de détecteur et détecteur semi-conducteur doté d'un cristal à motifs

(43) Date of publication of application: 28.04.2010
(73) Proprietor: Oxford Instruments Analytical Oy, 02631 Espoo (FI)
(72) Inventor: Sipilä, Heikki, 02270, ESPOO (FI); Andersson, Hans, 01630, Vantaa (FI); Nenonen, Seppo, 02730, ESPOO (FI); Kalliopuska, Juha, 02230 Espoo (FI)
(74) Representative: Brax, Matti Juhani

(56) References cited:
- US-A- 6 162 658
- US-A1- 2004 222 358
- US-A1- 2007 176 200
- US-A1- 2008 067 622

## Description

### TECHNICAL FIELD

The invention concerns in general the technology of solid-state semiconductor-based radiation detectors. Especially the invention concerns the problem of patterning a detector element, which essentially consists of a semiconductor piece with a PN junction on one side.

### BACKGROUND OF THE INVENTION

The use of solid-state radiation detectors is based on exposing a semiconductor piece to incoming radiation. The interaction of a received photon with the semiconductor material creates a number of electron/hole pairs, also referred to as free charge carriers. At least one species of free charge carriers are accumulated to electrodes connected to the semiconductor material, and the amount of electric charge thus collected is measured. The total amount of collected charge reveals the original energy of the received photon. If the detector has spatial resolution, detecting the location at which the charge cloud was created enables using the measurement results for imaging. The semiconductor piece is often referred to as the crystal, because detectors of best quality require a single-crystal semiconductor piece with as few lattice faults as possible.

Patterning a detector crystal may have various aims. Dividing the detector crystal into discrete pixels enables making an imaging detector, in which the charge collected by each pixel can be read separately. Even if the detector is not meant for imaging, patterns on the crystal surface may be used as guard structures that control and limit the flow of charges in the crystal.

Known methods for patterning a detector crystal include at least photolithography and ion beam based methods. The former refers to a family of processes, the common features of which include depositing a photoresist on a surface to be patterned, selectively hardening the photoresist through exposure to light, and utilizing the chemical differences between hardened and non-hardened photoresist to etch out desired portions of the surface beneath the photoresist. Ion beam deposition may also use a photoresist, but the eventual mechanism of actual pattern production is not chemical etching but ions abrading away the areas not covered by the photoresist. Focused ion beam techniques are also available and can be used for example to directly inject new material onto the surface to be patterned. Document US2007/0176200 A discloses a radiation detector comprising CdTe.

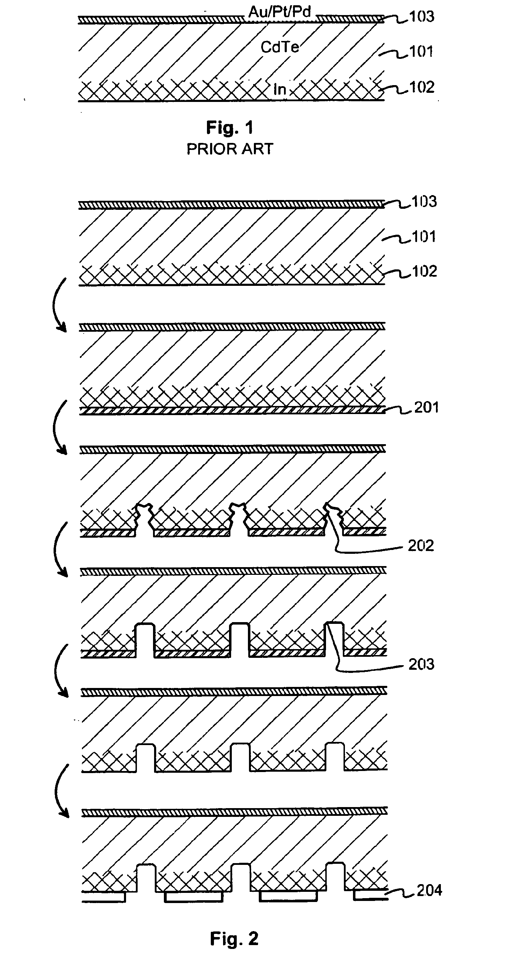

The above-mentioned methods are not sufficient for good results in all patterning applications. As an example we may consider the case of fig. 1, which shows a cadmium telluride (CdTe) detector crystal 101 with a diffused indium layer 102 on its back surface. The front surface has a thin contact layer 103 made of a metal, like gold, platinum or palladium. The terms "front" and "back" are here used in the conventional sense to tell that the radiation to be detected is meant to enter through that surface that has the metal contact layer 103. The thicknesses of the layers are not to scale. In practice, the thickness of the detector crystal 101 could be in the order of millimetres, the thickness of the diffused indium layer 102 could be in the order of tens of micrometers, and the thickness of the metal contact layer 103 could be in the order of nanometers.

It would be relatively easy to add spatial resolution to the detector of fig. 1 by patterning the metal contact layer 103 with e.g. photolithographic methods. However, using the front surface for patterning would mean that also the readout electronics should be located on the front surface of the detector, where they may interfere with the incoming radiation. The diffused indium layer 102 is typically too thick (in the order of some tens of micrometers) to be patterned with e.g. photolithography.

Basically it would be possible to replace the thick diffused indium layer 102 with a thin metal contact also on the back surface, which thin metal contact could then be patterned. However, this would easily lead to an unacceptably high leakage current in the detector. The PN junction at the interface between cadmium telluride and indium is vital in curbing the leakage current.

### SUMMARY OF THE INVENTION

An objective of the present invention is to present a method for patterning a solid-state semiconductor detector, as recited in claim 1. A further objective of the present invention is to present a patterning method that is applicable to detector crystals having thick diffused layers. Yet another objective of the invention is to present a patterned semiconductor detector with low leakage current and small number of lattice faults.

The objectives of the invention are achieved by selectively removing material from the surface of a layered structure where a diffused layer covers a semiconductor crystal, so that grooves thus produced penetrate deeper into said layered structure than the thickness of said diffused layer.

A method according to the invention is characterized in that it comprises the steps as recited in claim 1.

A semiconductor detector according to the invention is as recited in claim 10.

The thickness of the diffused layer means that selectively removing material from that side of the detector crystal must be accomplished with a method that will reach deep enough into the crystal without causing excessive damage to the lattice structure. Suitable methods include at least the use of a spatially controllable Q-switched laser, sawing, and plasma etching.

A Q-switched laser is a device capable of creating an exceptionally high power density at a very small focal point area. If focused on a surface, the output pulse of a Q-switched laser will convert a part of the surface material into a state of plasma, so that a certain amount of the material is ejected leaving an empty cavity on the surface. Repeated application of Q-switched laser pulses at the same location will make the cavity deeper, and moving the focal point across the surface will cause a groove to be created.

A detector crystal that has a relatively thick diffused layer on its back surface can be patterned by using a Q-switched laser to "saw" grooves in the back surface. If the grooves reach deeper than the thickness of the diffused layer, and if a groove or a number of intersecting grooves form a closed contour, they effectively isolate an island or a number of islands of the diffused material from the remaining parts of the original crystal surface. If independent electric contacts are made to a number of islands so isolated, the charge collected by each island can be separately measured, which means that the detector has spatial resolution.

Using a Q-switched laser to produce said grooves has the advantage that the amount of excess energy that is distributed to the remaining atoms of the crystal lattice is relatively low, resulting in a correspondingly low number of permanent faults introduced into the crystal lattice. If cleaning of the grooves is nevertheless required, it can be done by e.g. wet etching. Since the Q-switched laser eats its way easily through a photoresist, it is not necessary to preproduce any patterns into the resist layer before the application of the Q-switched laser.

Other viable methods for producing the grooves include but are not limited to mechanical sawing and plasma etching.

The exemplary embodiments of the invention presented in this patent application are not to be interpreted to pose limitations to the applicability of the appended claims. The verb "to comprise" is used in this patent application as an open limitation that does not exclude the existence of also unrecited features. The features recited in depending claims are mutually freely combinable unless otherwise explicitly stated.

The novel features which are considered as characteristic of the invention are set forth in particular in the appended claims. The invention itself, however, both as to its construction and its method of operation, together with additional objects and advantages thereof, will be best understood from the following description of specific embodiments when read in connection with the accompanying drawings.

### BRIEF DESCRIPTION OF DRAWINGS

- Fig. 1: illustrates a known, unpatterned CdTe semiconductor detector,
- fig. 2: illustrates the preparation of a patterned detector crystal,
- fig. 3: illustrates a patterned detector crystal with pixels,
- fig. 4: illustrates a patterned detector crystal with a guard ring, and
- fig. 5: illustrates a method for patterning a detector crystal.

### DETAILED DESCRIPTION OF THE INVENTION

Q-switched lasers represent known technology, but for clarity some of their features are summarized here. Passive Q-switching involves using a piece of optical gain medium in connection with a saturable absorber, also known as the passive Q-switch. Optical energy is pumped into the gain medium using e.g. a so-called pump laser. A saturation effect in the absorber leads to a rapid reduction of resonator loss, so that energy temporarily stored in the gain medium is instantaneously extracted in the form of a laser pulse. The cycle of storing and releasing energy is repeated at a rate determined by the pumping power and the characteristics of the saturable absorber. As a difference to passive Q-switching, active Q-switching involves using a medium with actively controllable optical characteristics in place of the saturable absorber.

A laser machining apparatus that employs a Q-switched laser typically includes controllable focusing means, with which it is possible to choose very exactly the location at which the laser pulses will hit the target surface, and also to move the focal point of the laser pulses very exactly across the target surface along a predefined route. The controllable focusing means may include e.g. piezoelectrically controlled mirrors, lenses and so forth. The predefined route, along which the focal point should be moved, may include straight sections, curved sections and discontinuities (which are implemented by switching the laser on and off according to need). The speed at which the focal point will be moved, as well as the output power of the Q-switched laser system can be controlled exactly. This means that when the resistance of the target material to laser machining is known, it is possible to predict relatively exactly, how deep a groove will result from a certain movement of the focal point across the target surface.

In fig. 2 the topmost cross-section represents a detector crystal 101 that comprises a relatively thick diffused layer 102 on its back surface and a thin contact layer 103 on its front surface. Actually it is quite irrelevant whether the detector crystal comprises anything on its front surface at this moment; the thin contact layer 103 is there merely to underline that prepared crystals of this kind are easily obtained e.g. from production lines that conventionally have produced non-patterned detectors of the type illustrated in fig. 1. Similarly to fig. 1 also here the layer thicknesses are not to scale.

In fig. 2 we assume that some further processing steps will benefit from the application of a photoresist layer 201 onto the back surface of the crystal. After applying the photoresist a Q-switched laser is used to produce initial grooves 202 that penetrate from the back surface deep enough into the crystal 101 to go through the diffused layer 102. Depending on the accuracy of controlling the Q-switched laser apparatus and other factors, the initial grooves 202 may first have somewhat rough edges. Wet etching is used to clean and smooth the grooves, so that nice clean final grooves 203 are produced. Assuming that the photoresist layer 201 is not needed for anything else, it can be removed. In order to utilize the thus accomplished patterning there are formed some kinds of contacts 204 and possibly readout electronics onto the exposed surfaces of the patterns, using known methods of semiconductor circuit production.

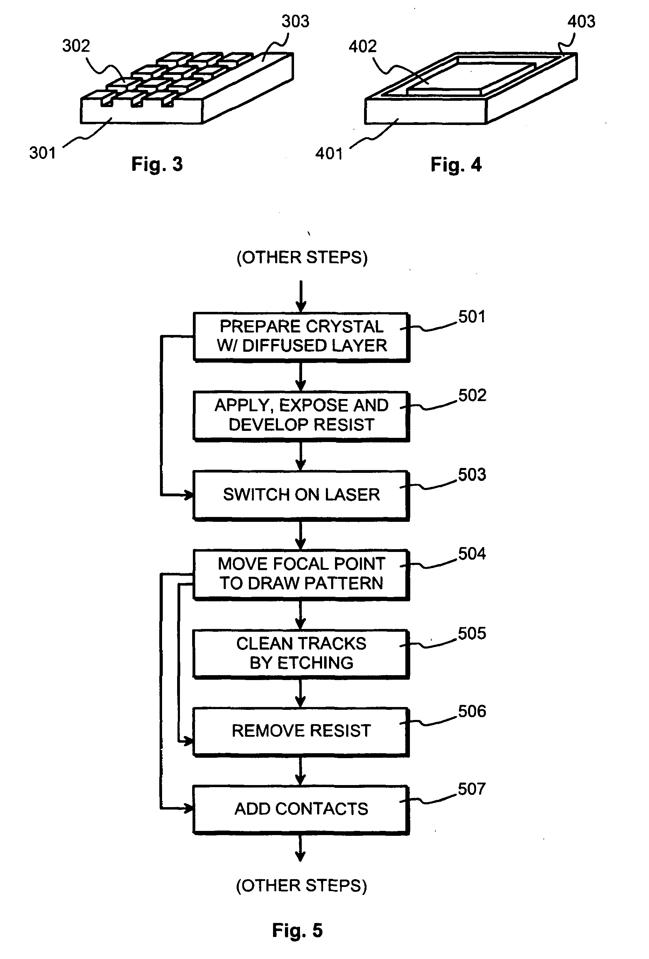

Some possible results of patterning are shown in figs. 3 and 4. Fig. 3 illustrates schematically a patterned detector crystal 301, the back surface of which comprises pixels 302 separated from each other by laser-machined grooves. One portion 303 of the back surface has been left without grooves to enable using it the substrate for readout electronics. Fig. 4 illustrates schematically a patterned detector crystal which does not need to have spatial resolution, but in which a guard ring consisting of a groove in the form of a closed curve separates a central part 402 from an edge portion 403. Many other ways of patterning, including but not being limited to various combinations of the principles shown in figs. 3 and 4, are possible.

Fig. 5 illustrates a method according to an embodiment of the invention. At some stage of manufacturing a semiconductor radiation detector, there is prepared a crystal with a relatively thick diffused layer on its back side according to step 501. Whether or not the process involves applying a resist on the surface of the diffused layer is not important to the invention, which in fig. 5 is illustrated as a possible straight transition from step 501 to step 503 as an alternative to the route going through the step 502 of applying a resist. Even if a resist is used to protect those portions of the diffused surface against a later etching step that should remain intact, it is interesting to note that step 502 does not need to include using any masks or other ways to pattern the resist, because the laser will easily go through the resist also. Thus it is sufficient to apply a smooth, even layer of resist in step 502 and expose and develop it all, if a resist is needed.

Using a Q-switched laser to machine grooves through the diffused layer is illustrated relatively simply as switching on the laser in step 503, focusing the Q-switched laser into a focal point on the surface to be machined and moving the focal point across the surface in step 504. In practice, especially if the groove patterns to be produced are complicated, the machining phase may include numerous steps of controlling the use of the laser in various ways. Moving the focal point may include moving the laser apparatus, otherwise controlling the aim of the laser apparatus, moving the crystal in relation with the laser apparatus, or a combination of any of these.

If the laser machining leaves the grooves clean enough, it is possible that no etching is required, but for the sake of completeness a possible etching step is illustrated as step 505. Here we also assume that the resist that was possibly applied in step 502 was there indeed for the purpose of protecting the desired remaining portions of the diffused surface, so the remaining resist can be removed in step 506. Step 507 involves producing the required contacts and possibly other circuit elements on the patterned surface according to need, using techniques known as such.

If mechanical sawing or plasma etching is used to produce the grooves, steps 503 and 504 are replaced by switching on the appropriate tooling apparatus and moving the tooling blade or plasma cannon in relation to the semiconductor crystal (again, all possible ways of causing relative movement are possible).

It should be noted that even if we speak above about producing a single detector, it is in many cases most advantageous to handle an array of detector preforms simultaneously, so that they are all produced from a single cadmium telluride wafer that goes through the process illustrated in fig. 5.

## Claims

1. A method for patterning a semiconductor radiation detector crystal, comprising:
- producing a diffused indium layer on a back surface of a cadmium telluride substrate of said semiconductor radiation detector crystal, and
- selectively removing material from said back surface of said semiconductor radiation detector crystal, thus producing a groove in said back surface that penetrates deeper into said cadmium telluride substrate than the thickness of said diffused indium layer on said back surface and isolates an island of indium-diffused cadmium telluride material on said back surface from other parts of said back surface.

2. A method according to claim 1, wherein said groove constitutes a closed curve around said island of indium-diffused cadmium telluride material.

3. A method according to claim 2, comprising isolating a plurality of islands of indium-diffused cadmium telluride material on said back surface from each other, and making independent electric contacts to a number of islands so isolated, said independent electric contact being adapted to enable measuring an amount of charge collected by each of said number of islands separately.

4. A method according to claim 2, comprising isolating a portion of diffused material on said back surface from a remainder of said back surface with a guard ring that comprises a groove in the form of a closed curve around said portion of diffused material on said back surface.

5. A method according to claim 1, wherein the selective removing of material is accomplished by focusing a Q-switched laser into a focal point on said back surface and moving the focal point in relation to said semiconductor radiation detector crystal.

6. A method according to claim 5, comprising:
- using wet etching to remove material from a groove produced with said Q-switched laser.

7. A method according to claim 6, comprising:
- prior to using said Q-switched laser to selectively remove material from said back surface, covering said back surface with a resist,
- using said Q-switched laser to selectively remove both resist and material of said semiconductor radiation detector crystal to produce said groove, and leaving a portion of resist intact on a portion of said back surface, and
- utilizing said portion of resist that was left intact to protect said portion of said back surface during said wet etching.

8. A method according to claim 1, wherein the selective removing of material is accomplished by mechanically sawing off material.

9. A method according to claim 1, comprising selectively removing material from said back surface by plasma etching.

10. A semiconductor radiation detector, comprising:
- a detector crystal made of cadmium telluride,
- a diffused indium layer on a back surface of said detector crystal, said diffused indium layer giving rise to a PN junction between a front surface and said back surface of the detector crystal, and
- a groove in said back surface that penetrates deeper into the detector crystal than the thickness of said diffused indium layer and isolates an island of indium-diffused cadmium telluride material on said back surface from other parts of said back surface.

11. A semiconductor radiation detector according to claim 10, comprising a plurality of islands of indium-diffused cadmium telluride material on said back surface, said plurality of islands being isolated from each other by grooves, and independent electric contacts to a number of islands so isolated, said independent electric contact being adapted to enable measuring an amount of charge collected by each of said number of islands separately.

12. A semiconductor radiation detector according to claim 10, wherein said groove constitutes a guard ring that isolates a portion of diffused material on said surface from a remainder of said surface, which guard ring comprises a groove in the form of a closed curve around said portion of diffused material on said surface.

## Patentansprüche

1. Verfahren zur Musterung eines HalbleiterStrahlungsdetektorkristalls, welches Folgendes aufweist:
- Herstellen einer diffundierten Indiumschicht auf einer rückseitigen Fläche eines Kadmiumtellurid Substrats des Halbleiterstrahlunsdetektorkristalls, und
- Selektives Entfernen von Material von der rückseitigen Fläche des Halbleiterstrahlungsdetektorkristalls, um eine Vertiefung in der rückseitigen Fläche zu erzeugen, welche tiefer in das Kadmiumtelluridsubstrat eindringt als die Dicke der diffundierten Indiumschicht auf der rückseitigen Fläche und eine Insel von Indium-diffundiertem Kadmiumtelluridmaterial auf der rückseitigen Fläche von anderen Teilen der rückseitigen Fläche isoliert.

2. Verfahren nach Anspruch 1, wobei die Vertiefung eine geschlossene Kurve um die Insel des Indiumdiffundierten Kadmiumtelluridmaterials bildet.

3. Verfahren nach Anspruch 2, welches das Isolieren einer Vielzahl von Inseln von Indium-diffundiertem Kadmiumtelluridmaterial auf der rückseitigen Fläche voneinander und das Herstellen von unabhängigen elektrischen Kontakten mit einer Anzahl von auf diese Weise isolierten Inseln aufweist, wobei der unabhängige elektrische Kontakt dafür vorgesehen ist, das Messen einer Ladungsmenge zu ermöglichen, welche von jeder der Anzahl von Inseln separat gesammelt wurde.

4. Verfahren nach Anspruch 2, welche das Isolieren eines Abschnitts des diffundierten Materials auf der rückseitigen Fläche von einem Rest der rückseitigen Fläche mit einem Schutzring aufweist, welcher eine Vertiefung in der Form einer geschlossenen Kurve um den Abschnitt des diffundierten Materials auf der rückseitigen Fläche aufweist.

5. Verfahren nach Anspruch 1, wobei das selektive Entfernen von Material durch Fokussieren eines gütegeschalteten Lasers in einen Brennpunkt auf der rückseitigen Fläche und Bewegen des Brennpunkts relativ zu dem Halbleiterstrahlungsdetektorkristalls durchgeführt wird.

6. Verfahren nach Anspruch 5, welches Folgendes aufweist:
- Verwenden von Nassätzen, um Material aus einer mit dem gütegeschalteten Laser erzeugten Vertiefung zu entfernen.

7. Verfahren nach Anspruch 6, welches Folgendes aufweist:
- vor der Verwendung des gütegeschalteten Lasers das selektive Entfernen von Material von der rückseitigen Fläche, wobei die rückseitige Fläche mit einem Abdeckmittel abgedeckt wird,
- Verwenden des gütegeschalteten Lasers, um sowohl das Abdeckmittel als auch das Material des Halbleiterstrahlungsdete ktorkristalls selektiv zu entfernen, um die Vertiefung zu erzeugen, und Intaktlassen eines Abschnitts des Abdeckmittels auf einem Abschnitt der rückseitigen Fläche, und
- Verwenden des Abschnitts des Abdeckmittels, der intakt gelassen wurde, um den Abschnitt der rückseitigen Fläche während des Nassätzens zu schützen.

8. Verfahren nach Anspruch 1, wobei das selektive Entfernen von Material mittels mechanischem Absägen des Materials durchgeführt wird.

9. Verfahren nach Anspruch 1, welches das selektive Entfernen von Material von der rückseitigen Fläche durch Plasmaätzen aufweist.

10. Halbleiterstrahlungsdetektor, welcher Folgendes aufweist:
- ein aus Kadmiumtellurid hergestelltes Detektorkristall,
- eine diffundierte Indiumschicht auf einer rückseitigen Fläche des Detektorkristalls, wobei die diffundierte Indiumschicht einen PN-Übergang zwischen einer vorderen Fläche und der rückseitigen Fläche des Detektorkristalls verursacht, und
- eine Vertiefung in der rückseitigen Fläche, welche tiefer in den Detektorkristall eindringt als die Dicke der diffundierten Indiumschicht und eine Insel von Indium-diffundiertem Kadmiumtelluridmaterial auf der rückseitigen Fläche von anderen Teilen der rückseitigen Fläche isoliert.

11. Halbleiterstrahlungsdetektor nach Anspruch 10, welcher eine Vielzahl von Inseln von Indium-diffundiertem Kadmiumtelluridmaterial auf der rückseitigen Fläche, wobei die Vielzahl von Inseln mittels Vertiefungen voneinander isoliert sind, und unabhängige elektrische Kontakte zu einer Vielzahl von auf dieser Weise isolierten Inseln aufweist, wobei der unabhängige elektrische Kontakt dafür vorgesehen ist, das Messen einer Ladungsmenge zu ermöglichen, welche von jeder der Anzahl von Inseln separat gesammelt wurde.

12. Halbleiterstrahlungsdetektor nach Anspruch 10, wobei die Vertiefung einen Schutzring bildet, welcher einen Abschnitt des diffundierten Materials auf der Oberfläche von einem Rest der Oberfläche isoliert, wobei der Schutzring eine Nut in der Form einer geschlossenen Kurve um den Abschnitt des diffundierten Materials auf der rückseitigen Fläche aufweist.

## Revendications

1. Procédé de mise en forme d'un cristal de détecteur de rayonnement à semi-conducteur, comprenant le fait :
de produire une couche d'indium diffusée sur une face arrière d'un substrat de tellurure de cadmium dudit cristal de détecteur de rayonnement à semi-conducteur, et
d'enlever sélectivement du matériau de ladite face arrière dudit cristal de détecteur de rayonnement à semi-conducteur, produisant ainsi un sillon dans ladite face arrière qui s'enfonce dans ledit substrat de tellurure de cadmium plus que l'épaisseur de ladite couche d'indium diffusée sur ladite face arrière et isole un îlot de matériau de tellurure de cadmium à indium diffusé dans ladite face arrière, d'autres parties de ladite face arrière.

2. Procédé selon la revendication 1, dans lequel ledit sillon constitue une courbe fermée autour dudit îlot de matériau de tellurure de cadmium à indium diffusé.

3. Procédé selon la revendication 2, comprenant le fait d'isoler une pluralité d'îlots de matériau de tellurure de cadmium à indium diffusé sur ladite face arrière les uns des autres, et d'établir des contacts électriques indépendants au niveau de certains des îlots isolés, ledit contact électrique indépendant étant conçu pour permettre la mesure d'une quantité de charge collectée par chacun de ladite pluralité d'îlots séparément.

4. Procédé selon la revendication 2, comprenant le fait d'isoler une partie de matériau diffusé sur ladite face arrière du reste de celle-ci avec une bague de garde qui comprend un sillon sous forme de courbe fermée autour de ladite partie de matériau diffusé sur ladite face arrière.

5. Procédé selon la revendication 1, dans lequel l'enlèvement sélectif de matériau est réalisé en focalisant un laser déclenché en un point focal sur ladite face arrière et en déplaçant le point focal par rapport audit cristal de détecteur de rayonnement à semi-conducteur.

6. Procédé selon la revendication 5, comprenant le fait :
d'utiliser une gravure humide afin d'enlever du matériau d'un sillon produit à l'aide dudit laser déclenché.

7. Procédé selon la revendication 6, comprenant le fait :
de recouvrir ladite face arrière avec une réserve avant l'utilisation dudit laser déclenché pour enlever sélectivement du matériau de ladite face arrière,
d'utiliser ledit laser déclenché pour enlever sélectivement à la fois du matériau et le masque de réserve dudit cristal de détecteur de rayonnement à semi-conducteur afin de produire ledit sillon, et de laisser une partie du masque de réserve intacte sur une partie de ladite face arrière, et
d'utiliser ladite partie du masque de réserve qui a été laissée intacte afin de protéger ladite partie de ladite face arrière pendant ladite gravure humide.

8. Procédé selon la revendication 1, dans lequel l'enlèvement sélectif de matériau est réalisé par sciage du matériau.

9. Procédé selon la revendication 1, comprenant le fait d'enlever sélectivement du matériau de ladite face arrière par gravure au plasma.

10. Détecteur de rayonnement à semi-conducteur comprenant :
un cristal de détecteur réalisé en tellurure de cadmium,
une couche d'indium diffusée sur une face arrière dudit cristal du détecteur, ladite couche d'indium diffusée procurant une jonction PN entre une face avant et ladite face arrière du cristal du détecteur, et
un sillon dans ladite face arrière qui s'enfonce dans le cristal du détecteur plus que l'épaisseur de ladite couche d'indium diffusée et isole un îlot de matériau de tellurure de cadmium à indium diffusé sur ladite face arrière d'autres parties de ladite face arrière.

11. Détecteur de rayonnement à semi-conducteur selon la revendication 10, comprenant une pluralité d'îlots de matériau de tellurure de cadmium à indium diffusé sur ladite face arrière, ladite pluralité d'îlots étant isolés les uns des autres par des sillons, et des contacts électriques indépendants au niveau de certains des îlots isolés, ledit contact électrique indépendant étant conçu pour permettre la mesure d'une quantité de charge collectée par chacun dudit nombre d'îlots séparément.

12. Détecteur de rayonnement à semi-conducteur selon la revendication 10, dans lequel ledit sillon constitue une bague de garde qui isole une partie de matériau diffusé sur ladite face du reste de ladite face, laquelle bague de garde comprend un sillon sous forme d'une courbe fermée autour de ladite partie de matériau diffusé sur ladite face.
